Europäisches Patentamt

European Patent Office

Office européen des brevets

(19)

(11)  EP 1 553 454 A2

(12)  **EUROPEAN PATENT APPLICATION**

(43)  Date of publication:
    **13.07.2005  Bulletin 2005/28**

(51)  Int Cl.[7]:  **G03F 7/16**, G03F 7/32,
    **G03F 7/40**

(21)  Application number: **04029998.4**

(22)  Date of filing: **17.12.2004**

(84)  Designated Contracting States:
    **AT BE BG CH CY CZ DE DK EE ES FI FR GB GR
    HU IE IS IT LI LT LU MC NL PL PT RO SE SI SK TR**
    Designated Extension States:
    **AL BA HR LV MK YU**

(30)  Priority:  **22.12.2003  JP 2003424563
            25.02.2004  JP 2004049349**

(71)  Applicant: **MATSUSHITA ELECTRIC INDUSTRIAL
    CO., LTD.
    Kadoma-shi, Osaka 571-8501 (JP)**

(72)  Inventors:
    •  **Endo, Masayuki
      Kishiwada-shi Osaka 596-0825 (JP)**
    •  **Sasago, Masaru
      Hirakata-shi Osaka 573-0007 (JP)**

(74)  Representative: **Grünecker, Kinkeldey,
    Stockmair & Schwanhäusser Anwaltssozietät
    Maximilianstrasse 58
    80538 München (DE)**

(54)  **Pattern formation method**

(57)    In a pattern formation method of this invention, a resist film is formed on a substrate and pattern exposure is performed by selectively irradiating the resist film with exposing light. Subsequently, the resist film is developed after the pattern exposure, and the developed resist film is rinsed with an aqueous solution including cyclodextrin.

Methods are also disclosed involving either developing with a solution including cyclodextrin or rinsing with an aqueous solution including a surfactant.

Thus a fine resist pattern made of the resist film is formed without causing pattern collapse.

FIG. 1

EP 1 553 454 A2

## Description

## CROSS-REFERENCE TO RELATED APLICATIONS

This application claims priority under 35 U.S.C. §119 on Patent Application Nos. 2003-424563 and 2004-49349 filed in Japan respectively on December 22, 2003 and February 25, 2004, the entire contents of which are hereby incorporated by reference.

## BACKGROUND OF THE INVENTION

The present invention relates to a pattern formation method for use in fabrication process or the like for semiconductor devices.

In accordance with the increased degree of integration of semiconductor integrated circuits and downsizing of semiconductor devices, there are increasing demands for higher performance of lithography technique. In particular, in order to refine patterns, pattern formation is currently carried out through photolithography using exposing light of a mercury lamp, KrF excimer laser, ArF excimer laser or the like, and use of $F_2$ laser lasing at a shorter wavelength is being examined. Simultaneously, examinations are being made for increasing the NA (numerical aperture) of an exposure system.

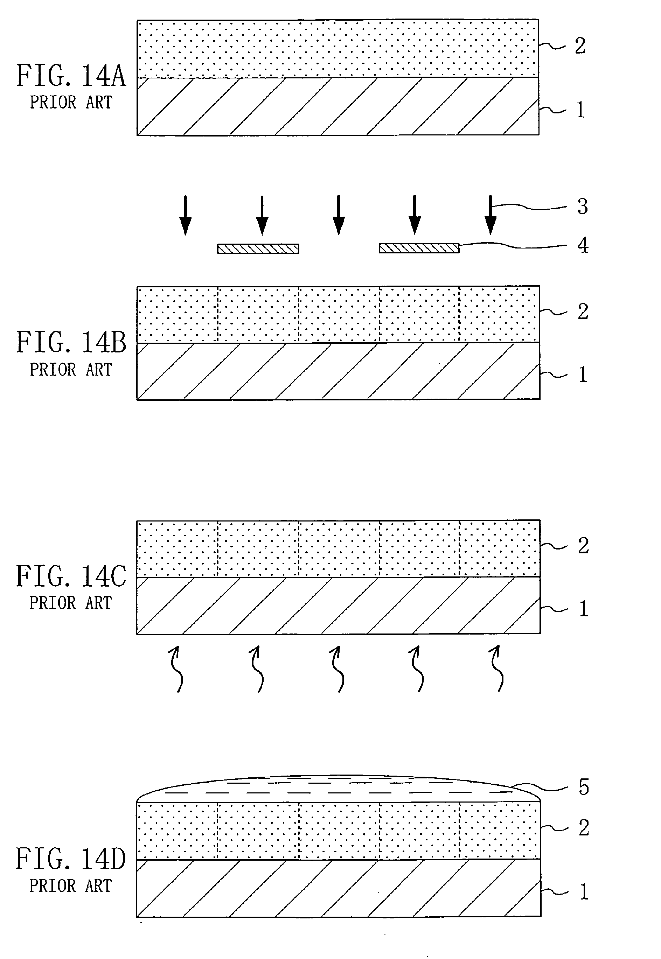

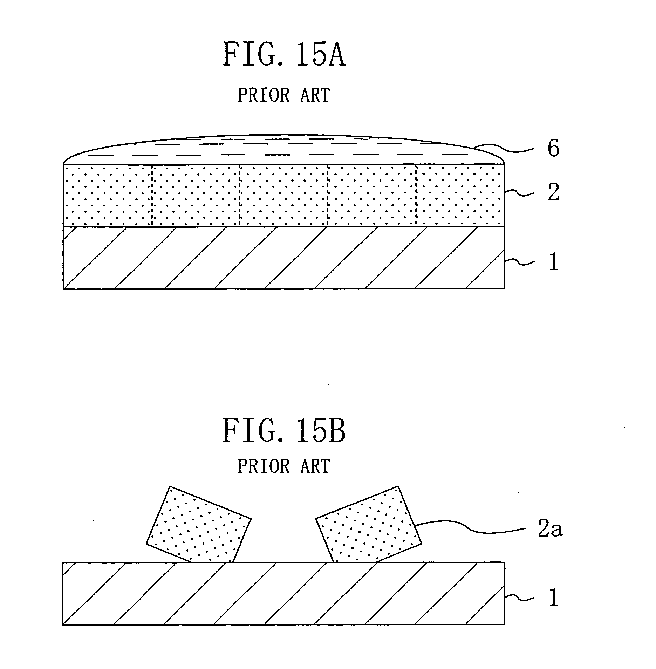

Now, a conventional pattern formation method will be described with reference to FIGS. **14A** through **14D, 15A** and **15B.**

First, a positive chemically amplified resist material having the following composition is prepared:

Base polymer: poly((norbornene-5-methylene-t-butylcarboxylate) (50 mol%) - (maleic anhydride) (50 mol%))      2 g

Acid generator: triphenylsulfonium triflate      0.06 g

Solvent: propylene glycol monomethyl ether acetate      20 g

Next, as shown in FIG. **14A**, the aforementioned chemically amplified resist material is applied on a substrate **1** so as to form a resist film **2** with a thickness of 0.5 μm.

Then, as shown in FIG. **14B,** pattern exposure is carried out by irradiating the resist film **2** with exposing light **3** of ArF excimer laser with NA of 0.68 through a mask **4**.

After the pattern exposure, as shown in FIG. **14C**, the resist film **2** is baked with a hot plate at a temperature of 100°C for 60 seconds (post exposure bake).

Next, as shown in FIG **14D**, the resultant resist film **2** is developed with a 2.38 wt% tetramethylammonium hydroxide developing solution **5**.

Then, as shown in FIG. **15A,** the developed resist film **2** is rinsed with a rinsing solution **6** of water. In this manner, a resist pattern **2a** made of an unexposed portion of the resist film **2** and having a line width of 0.09 μm is formed as shown in FIG. **15B**.

## SUMMARY OF THE INVENTION

However, the resist pattern **2a** formed by the conventional pattern formation method disadvantageously collapses as shown in FIG. **15B** although it is refined owing to the short wavelength of the exposing light **3** and the increased NA. Hereinafter, this phenomenon that a pattern collapses is designated as pattern collapse.

An object of the invention is preventing the pattern collapse of a fine resist pattern by reducing surface tension against the resist pattern caused by a solution used in development.

Specifically, the first pattern formation method of this invention includes the steps of forming a resist film on a substrate; performing pattern exposure by selectively irradiating the resist film with exposing light; developing the resist film after the pattern exposure; and forming a resist pattern by rinsing the resist film with an aqueous solution including cyclodextrin after the developing.

In the first pattern formation method, the developed resist film is rinsed with the aqueous solution including the cyclodextrin, and therefore, the cyclodextrin having hydrophilic groups is adhered onto the surface of the resist film or the resist pattern. Owing to the adhered cyclodextrin, surface tension against the resist pattern caused when the rinsing solution dries is reduced, resulting in preventing pattern collapse derived from the surface tension against the resist pattern.

The second pattern formation method of this invention includes the steps of forming a resist film on a substrate; performing pattern exposure by selectively irradiating the resist film with exposing light; developing the resist film with a solution including cyclodextrin after the pattern exposure; and forming a resist pattern by rinsing the resist film with an aqueous solution after the developing.

In the second pattern formation method, the development is performed by using the solution including the cyclodextrin, and therefore, the cyclodextrin having hydrophilic groups is adhered onto and remains on the surface of the resist film or the resist pattern in the development. Owing to this remaining cyclodextrin, the surface tension against the resist pattern caused when the rinsing solution dries is reduced, resulting in preventing the pattern collapse derived from the surface tension against the resist pattern.

Also in the second pattern formation method, the aqueous solution used in rinsing preferably includes cyclodextrin.

The concentration of the cyclodextrin in the rinsing solution or the solution is appropriately approximately not less than 0.001 wt% and not more than 1 wt%, which does not limit the invention.

In the first or second pattern formation method, the cyclodextrin may be α-cyclodextrin, β-cyclodextrin, γ-cyclodextrin or δ-cyclodextrin.

In the first or second pattern formation method, the aqueous solution preferably includes a surface active agent.

In the second pattern formation method, the solution preferably includes a surface active agent. Thus, the hydrophilic property of the cyclodextrin is further improved owing to the polarization function of the surface active agent. The concentration of the surface active agent is appropriately approximately not less than $1 \times 10^{-5}$ wt% and not more than $1 \times 10^{-2}$ wt%, which does not limit the invention.

Also, the surface active agent may be a cationic surface active agent or a nonionic surface active agent.

The third pattern formation method of this invention includes the steps of forming a resist film including a surface active agent on a substrate; performing pattern exposure by selectively irradiating the resist film with exposing light; developing the resist film after the pattern exposure; and forming a resist pattern by rinsing the resist film with an aqueous solution including a surface active agent after the developing.

In the third pattern formation method, since the resist film itself includes the surface active agent, hydrophilic groups of the surface active agent are uniformly distributed on the resist film in the step of rinsing the developed resist film with the aqueous solution including the surface active agent. Therefore, the surface tension caused when the rinsing solution dries is definitely reduced. Owing to this reduction of the surface tension, the pattern collapse caused in the resist pattern when the rinsing solution dries can be prevented.

The fourth pattern formation method of this invention includes the steps of forming a resist film on a substrate; exposing the resist film to a first aqueous solution including a surface active agent; performing pattern exposure by selectively irradiating the resist film with exposing light after exposing the resist film to the first aqueous solution; developing the resist film after the pattern exposure; and forming a resist pattern by rinsing the resist film with a second aqueous solution including a surface active agent after the developing.

In the fourth pattern formation method, since the resist film is exposed to the first aqueous solution including the surface active agent, the surface of the resist film with a hydrophobic property is made to be hydrophilic, and furthermore, hydrophilic groups of the surface active agent are uniformly distributed on the surface of the resist film in the step of rinsing the developed resist film with the second aqueous solution including the surface active agent. Therefore, the surface tension caused when the rinsing solution dries is definitely reduced. Owing to this reduction of the surface tension, the pattern collapse caused in the resist pattern when the rinsing solution dries can be prevented.

Preferably, the third or fourth pattern formation method further includes a step of rinsing the resist film with water after the developing and before rinsing the resist film with the second aqueous solution. Thus, the activity of the hydrophilic groups of the surface active agent included in the resist film or the surface active agent adhered onto the surface of the resist film is improved, and therefore, the surface tension caused when the rinsing solution dries can be further reduced.

In the third or fourth pattern formation method, the surface active agent included in the resist film, the surface active agent used for exposing the resist film or the surface active agent included in the rinsing solution may be a cationic surface active agent or a nonionic surface active agent.

In any of the first through fourth pattern formation methods, the cationic surface active agent may be cetylmethylammonium chloride, stearylmethylammonium chloride, cetyltrimethylammonium chloride, stearyltrimethylammonium chloride, distearyldimethylammonium chloride, stearyldimethylbenzylammonium chloride, dodecylmethylammonium chloride, dodecyltrimethylammonium chloride, benzylmethylammonium chloride, benzyltrimethylammonium chloride, benzalkonium chloride, 1,1-di(perfluoromethyl)-2-perfluoroethylethenyloxybenzyltrimethylammonium, 1,1-di(perfluoroisopropyl)-2-perfluoromethylethenyloxybenzyltrimethylammonium or the like.

Also, in any of the first through fourth pattern formation mehotds, the nonionic surface active agent may be nonyl phenol ethoxylate, octylphenyl polyoxyethylene ether, lauryl polyoxyethylene ether, cetyl polyoxyethylene ether, sucrose fatty ester, polyoxyethylene lanolin fatty ester, polyoxyethylene sorbitan fatty ester, polyoxyethylene glycol mono fatty ester, fatty monoethanolamide, fatty dietanolamide, fatty triethanolamide, 1,1-di(perfluoromethyl)-2-perfluoroethylethenyl polyoxyethylene ether, 1,1-di(perfluoroisopropyl)-2-perfluoromethylethenyl polyoxyethylene ether or the like.

The content of the surface active agent in the rinsing solution or in the resist film is appropriately approximately 0.0001 wt% through 0.01 wt%, which does not limit the invention.

In any of the first through fourth pattern formation methods, the exposing light may be KrF excimer laser, ArF excimer laser, $F_2$ laser, ArKr laser, $Ar_2$ laser, extreme UV of a wavelength band not shorter than 1 nm and not longer than 30 nm, or electron beams.

## BRIEF DESCRIPTION OF THE DRAWINGS

FIG. 1 is a cross-sectional view for showing the concept of prevention of pattern collapse of a resist pattern according to the present invention;

FIGS. **2A, 2B, 2C** and **2D** are cross-sectional views for showing procedures in a pattern formation method according to Embodiment 1 of the invention;
FIGS. **3A** and **3B** are cross-sectional views for showing other procedures in the pattern formation method of Embodiment 1;
FIGS. **4A, 4B, 4C** and **4D** are cross-sectional views for showing procedures in a pattern formation method according to Embodiment 2 of the invention;
FIGS. **5A** and **5B** are cross-sectional views for showing other procedures in the pattern formation method of Embodiment 2;
FIGS. **6A, 6B, 6C** and **6D** are cross-sectional views for showing procedures in a pattern formation method according to Embodiment 3 of the invention;
FIGS. **7A** and **7B** are cross-sectional views for showing other procedures in the pattern formation method of Embodiment 3;
FIGS. **8A, 8B, 8C** and **8D** are cross-sectional views for showing procedures in a pattern formation method according to Embodiment 4 of the invention;
FIGS. **9A** and **9B** are cross-sectional views for showing other procedures in the pattern formation method of Embodiment 4;
FIGS. **10A**, **10B**, **10C** and **10D** are cross-sectional views for showing procedures in a pattern formation method according to Embodiment 5 of the invention;
FIGS. **11A** and **11B** are cross-sectional views for showing other procedures in the pattern formation method of Embodiment 5;
FIGS. **12A**, **12B**, **12C** and **12D** are cross-sectional views for showing procedures in a pattern formation method according to Embodiment 6 of the invention;
FIGS. **13A** and **13B** are cross-sectional views for showing other procedures in the pattern formation method of Embodiment 6;
FIGS. **14A, 14B, 14C** and **14D** are cross-sectional views for showing procedures in a conventional pattern formation method;
FIGS. **15A** and **15B** are cross-sectional views for showing other procedures in the conventional pattern formation method; and
FIG. **16** is a cross-sectional view for explaining surface tension caused by a liquid remaining between adjacent resist patterns.

## DETAILED DESCRIPTION OF THE INVENTION

(Mechanism of Invention)

In general, surface tension caused when a rinsing solution dries works between patterns adjacent to each other. When an aspect ratio is high, the adjacent patterns cannot resist the surface tension of the rinsing solution, which causes pattern collapse (see, for example, H. Namatsu, K. Yamazaki and K. Kurihara, "Supercritical resist drier", J. Vac. Sci. Technol., Vol. B18, P. 780 (2000)).

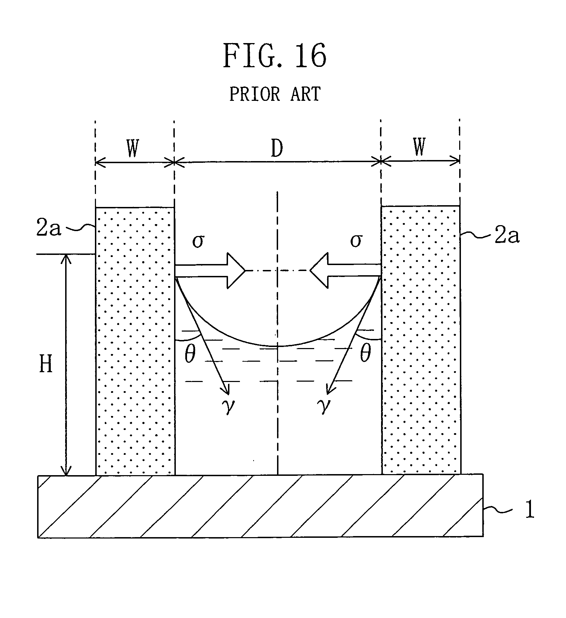

According to the aforementioned document, as shown in FIG. **16**, a force σ to collapse a resist pattern **2a** is represented by the following formula 1:

Formula 1:

$$\sigma = (6\gamma\cos\theta/D)\,(H/W)^2$$

wherein γ indicates the surface tension, θ indicates an angle between the direction of the surface tension and the side face of a resist pattern, **D** indicates a distance between the adjacent patterns, **H** indicates the height of the resist pattern, and **W** indicates the width of the resist pattern.

The height **H**, the width **W** and the distance **D** of the resist pattern are set values of a device and hence are not essentially changed. Accordingly, the only method for reducing the collapsing force σ is reducing the surface tension γ. Therefore, it is necessary to reduce the surface tension γ of a solution that affects the resist pattern in the development.

The present inventors have made various examinations on the method for reducing the surface tension of the solution that causes the pattern collapse of the resist pattern, resulting in finding the following:

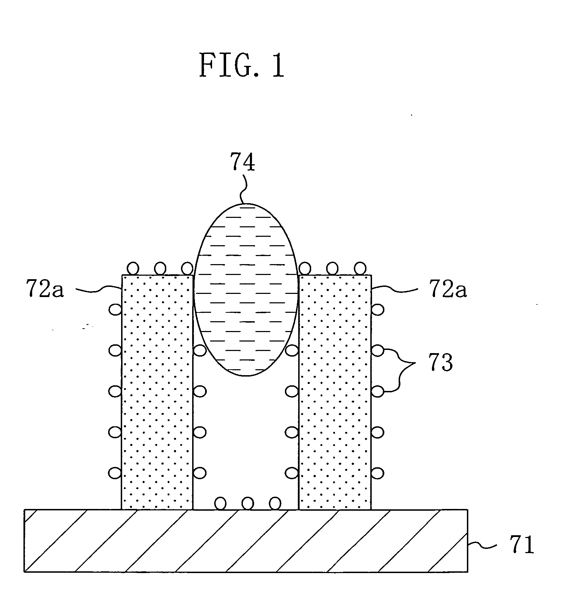

First, when cyclodextrin **3** is adhered onto a resist pattern **72a** formed on a substrate **71** as shown in FIG. **1**, the surface tension of a solution **74** of a developing solution or a rinsing solution is reduced.

Cyclodextrin has a structure in a trapezoidal cylindrical shape (bucket shape), and a plurality of hydroxyl groups are oriented toward the outside of the cylindrical shape and hydrophobic groups are oriented within the cylindrical shape. In other words, cyclodextrin incorporates a hydrophobic compound in the inside of the cylindrical shape while exhibiting, as a compound, a highly hydrophilic property owing to the hydrophilic groups oriented outside the cylindrical shape. Since an inclusion compound such as cyclodextrin, that is, an oligomer having a deformed structure in this manner, has ample hydrophilic groups, the surface tension caused when the solution **74** dries can be reduced.

Accordingly, when a compound having hydrophilic groups is adhered onto the surface of the resist pattern **72a**, a force to attract the resist pattern **72a** in a moving direction of the solution **74** caused through the interaction between the solution **74** and the resist pattern **72a** when the solution **74** is removed from the resist pattern **72a**, namely, the surface tension γ, can be weakened. This is for the following reason: Since the resist pattern **72a** is made of a compound having a comparatively strong hydrophobic property, in the interaction between such a compound having a hydrophobic property and a hydrophilic group, a force to repel from each other is stronger than a force to attract to each other. Therefore, the resist pattern **72a** minimally follows the movement of the solution. Accordingly, the pattern collapse caused after the development can be prevented owing to this phenomenon.

For example, when cyclodextrin is included in a rinsing solution, an effect to reduce the surface tension of the rinsing solution in the aforementioned manner can be attained. Alternatively, when cyclodextrin is included in a developing solution, since cyclodextrin adhered onto the surface of the resist pattern **72a** remains in the development, an effect to reduce the surface tension of a rinsing solution in rinsing can be attained. Needless to say, when cyclodextrin is included in both a developing solution and a rinsing solution, the effect is further increased.

Secondly, when not only a surface active agent is included in a rinsing solution but also a surface active agent is included in a resist film itself or a formed resist film is exposed to an aqueous solution including a surface active agent, the surface tension of the rinsing solution provided on the resist film can be reduced.

When a surface active agent is included in the resist film, hydrophilic groups of the surface active agent are uniformly oriented on the surface of the resist film. Since ion interaction is easily caused between a water-soluble component of a rinsing solution and the hydrophilic groups distributed on the resist film, the rinsing solution interacts with the surface active agent included in the resist film before permeating into the resist film. In other words, when the rinsing solution interacts with the surface active agent included in the resist film, the rinsing solution minimally permeates into the resist film. Therefore, a force to repel from each other is easily caused between the resist film with a hydrophobic property and the rinsing solution with a hydrophilic property, and hence, the surface tension of the rinsing solution provided on the resist film can be reduced.

Similarly, in the case where an aqueous solution including a surface active agent is supplied onto the resist film, the rinsing solution minimally permeates into the resist film due to the influence of the surface active agent, and therefore, the surface tension of the rinsing solution provided on the resist film can be reduced. As a result, the pattern collapse otherwise caused in the resist pattern can be prevented.

Now, preferred embodiments of the invention will be described.

EMBODIMENT 1

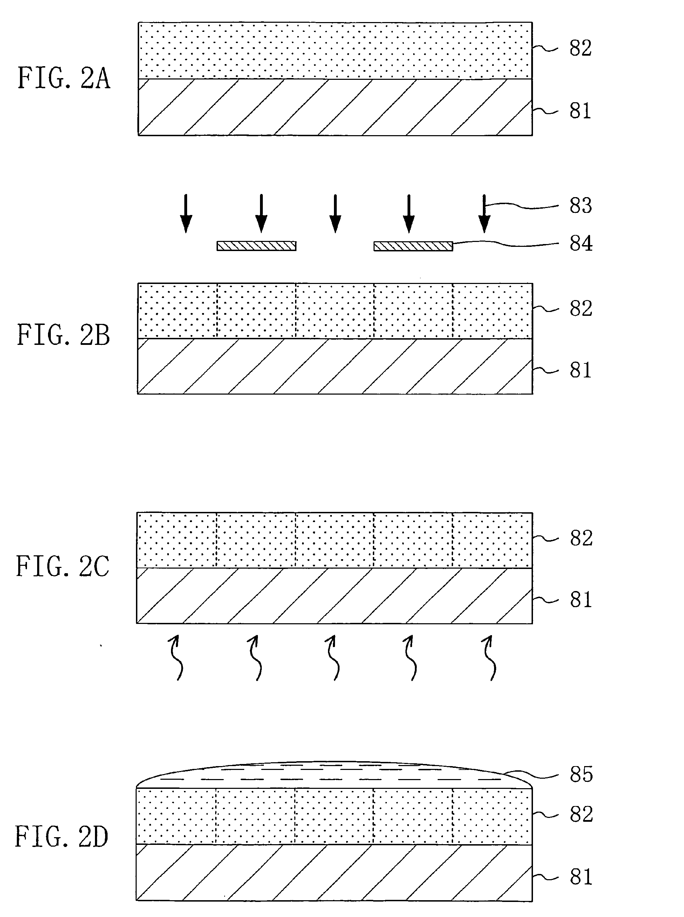

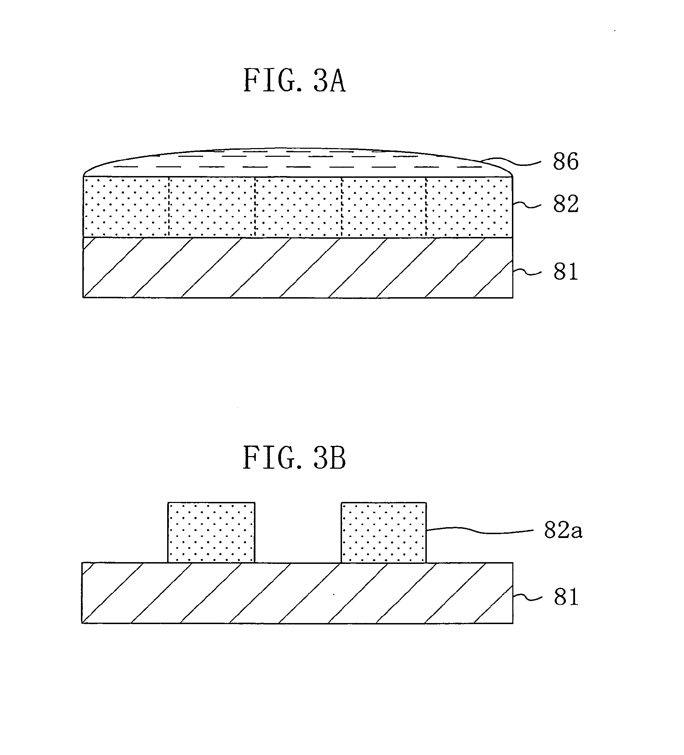

A pattern formation method according to Embodiment 1 of the invention will now be described with reference to FIGS. **2A** through **2D**, **3A** and **3B**.

First, a positive chemically amplified resist material having the following composition is prepared:

Base polymer: poly((norbornene-5-methylene-t-butylcarboxylate) (50 mol%) - (maleic anhydride) (50 mol%))     2 g
Acid generator: triphenylsulfonium triflate     0.06 g
Solvent: propylene glycol monomethyl ether acetate     20 g

Next, as shown in FIG. **2A**, the aforementioned chemically amplified resist material is applied on a substrate **81** so as to form a resist film **82** with a thickness of 0.5 µm.

Then, as shown in FIG. **2B**, pattern exposure is carried out by irradiating the resist film **82** with exposing light **83** of ArF excimer laser with NA of 0.68 through a mask **84.**

After the pattern exposure, as shown in FIG. **2C**, the resist film **82** is baked with a hot plate at a temperature of 100°C for 60 seconds (post exposure bake).

Next, as shown in FIG. **2D,** the resultant resist film **82** is developed with a 2.38 wt% tetramethylammonium hydroxide developing solution 85.

Then, as shown in FIG. **3A**, the developed resist film **82** is rinsed with a rinsing solution **86** including 0.01 wt% α-cyclodextrin. In this manner, a resist pattern **82a** made of an unexposed portion of the resist film **82** and having a line width of 0.09 µm is formed as shown in FIG. **3B**.

In this manner, according to the pattern formation method of Embodiment 1, since the rinsing solution 86 used after the development includes the cyclodextrin having hydrophilic groups, the surface tension against the resist pattern **82a** caused when the rinsing solution **86** dries is reduced. As a result, the resist pattern **82a** can be formed in a good shape without causing pattern collapse.

The cyclodextrin included in the rinsing solution **86** is not limited to α-cyclodextrin but may be β-cyclodextrin, γ-cyclodextrin or δ-cyclodextrin.

In Embodiment 1, the aspect ratio of the obtained resist pattern **82a** (the height/the width of the pattern) is 0.5/0.09, namely, as high as approximately 5.6. The present invention is particularly effective in application to a fine pattern with an aspect ratio of 3 or more in which patterns adjacent to each other collapse due to the surface tension of a rinsing solution or the like.

EMBODIMENT 2

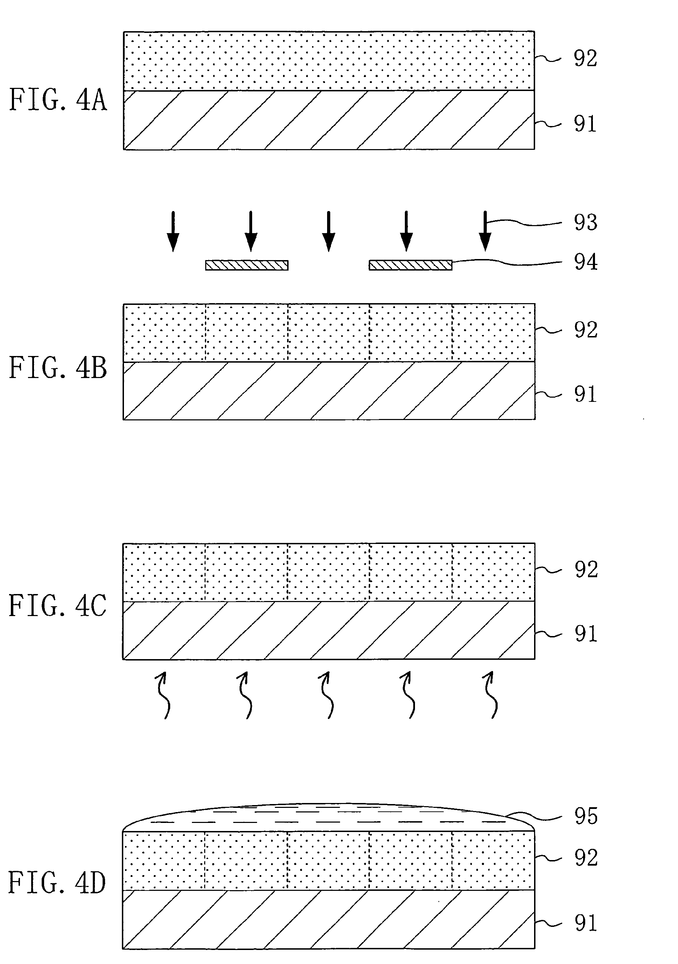

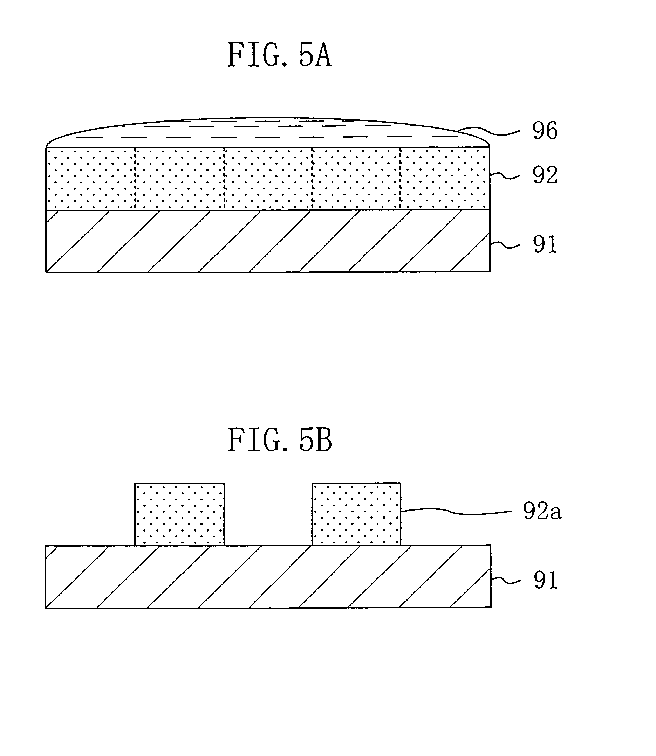

A pattern formation method according to Embodiment 2 of the invention will now be described with reference to FIGS. **4A** through **4D**, 5A and **5B**.

First, a positive chemically amplified resist material having the following composition is prepared:

Base polymer: poly((norbornene-5-methylene-t-butylcarboxylate) (50 mol%) - (maleic anhydride) (50 mol%))     2 g
Acid generator: triphenylsulfonium triflate     0.06 g
Solvent: propylene glycol monomethyl ether acetate     20 g

Next, as shown in FIG. **4A**, the aforementioned chemically amplified resist material is applied on a substrate **91** so as to form a resist film **92** with a thickness of 0.5 μm.

Then, as shown in FIG. **4B,** pattern exposure is carried out by irradiating the resist film **92** with exposing light **93** of ArF excimer laser with NA of 0.68 through a mask **94**.

After the pattern exposure, as shown in FIG. **4C**, the resist film **92** is baked with a hot plate at a temperature of 100°C for 60 seconds (post exposure bake).

Then, as shown in FIG. **4D**, the resultant resist film **92** is developed with a 2.38 wt% tetramethylammonium hydroxide developing solution **95** including 0.02 wt% β-cyclodextrin and a surface active agent of 1 x $10^{-4}$ wt% octylphenyl polyoxyethylene ether.

Next, as shown in FIG. **5A**, the developed resist film **92** is rinsed with a rinsing solution **96** of water. In this manner, a resist pattern **92a** made of an unexposed portion of the resist film **92** and having a line width of 0.09 μm is formed as shown in FIG. **5B**.

In this manner, according to the pattern formation method of Embodiment 2, since the developing solution **95** includes the cyclodextrin and the surface active agent having hydrophilic groups, the cyclodextrin and the surface active agent are adhered onto the surface of the resist pattern **92a** and remains in the development. Therefore, in rinsing the resist pattern **92a**, the surface tension against the resist pattern **92a** caused when the rinsing solution **96** dries is reduced by the cyclodextrin. Accordingly, the resist pattern **92a** can be formed in a good shape without causing pattern collapse.

The cyclodextrin included in the developing solution **95** is not limited to β-cyclodextrin but may be α-cyclodextrin, γ-cyclodextrin or δ-cyclodextrin.

Also in Embodiment 2, cyclodextrin may be included in the rinsing solution **96** as in Embodiment 1.

Although the effect to reduce the surface tension against the resist pattern **92a** by the cyclodextrin is increased by adding the surface active agent to the developing solution 95 in Embodiment 2, it is not always necessary to add the surface active agent.

The surface active agent included in the developing solution **95** is not limited to octylphenyl polyoxyethylene ether, that is, a nonionic surface active agent. As the nonionic surface active agent, instead of octylphenyl polyoxyethylene ether, nonyl phenol ethoxylate, lauryl polyoxyethylene ether, cetyl polyoxyethylene ether, sucrose fatty ester, polyoxyethylene lanolin fatty ester, polyoxyethylene sorbitan fatty ester, polyoxyethylene glycol mono fatty ester, fatty monoethanolamide, fatty diethanolamide, fatty triethanolamide, 1,1-di(perfluoromethyl)-2-perfluoroethylethenyl polyoxyethylene ether or 1,1-di(perfluoroisopropyl)-2-perfluoromethylethenyl polyoxyethylene ether may be used.

Alternatively, a cationic surface active agent may be used instead. In this case, cetylmethylammonium chloride, stearylmethylammonium chloride, cetyltrimethylammonium chloride, stearyltrimethylammonium chloride, distearyldimethylammonium chloride, stearyldimethylbenzylammonium chloride, dodecylmethylammonium chloride, dodecyltrimethylammonium chloride, benzylmethylammonium chloride, benzyltrimethylammonium chloride, benzalkonium chloride, 1,1-di(perfluoromethyl)-2-perfluoroethylethenyloxybenzyltrimethylammonium, or 1,1-di(perfluoroisopropyl)-2-perfluoromethylethenyloxybenzyltrimethylammonium may be used.

Furthermore, when any of the aforementioned surface active agents is included in the rinsing solution **86** of Embodiment 1, the effect to reduce the surface tension against the resist pattern by the cyclodextrin can be increased.

Moreover, in Embodiment 1 or 2, the exposing light **83** or **93** is not limited to the ArF excimer laser but may be KrF excimer laser, $F_2$ laser, ArKr laser, $Ar_2$ laser, extreme UV of a wavelength band not shorter than 1 nm and not longer than 30 nm, or electron beams.

EMBODIMENT 3

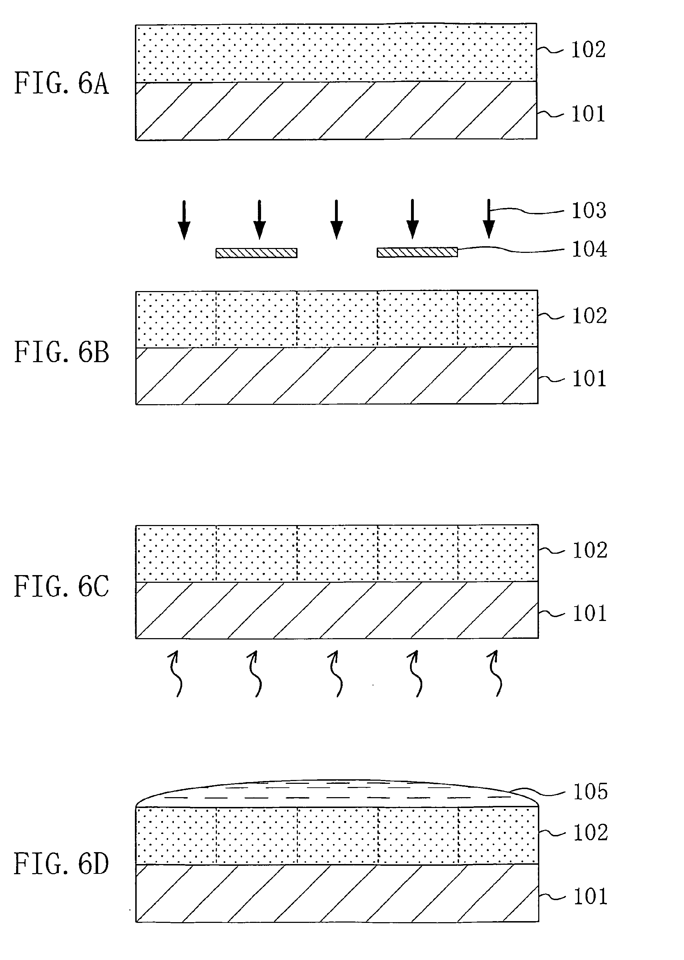

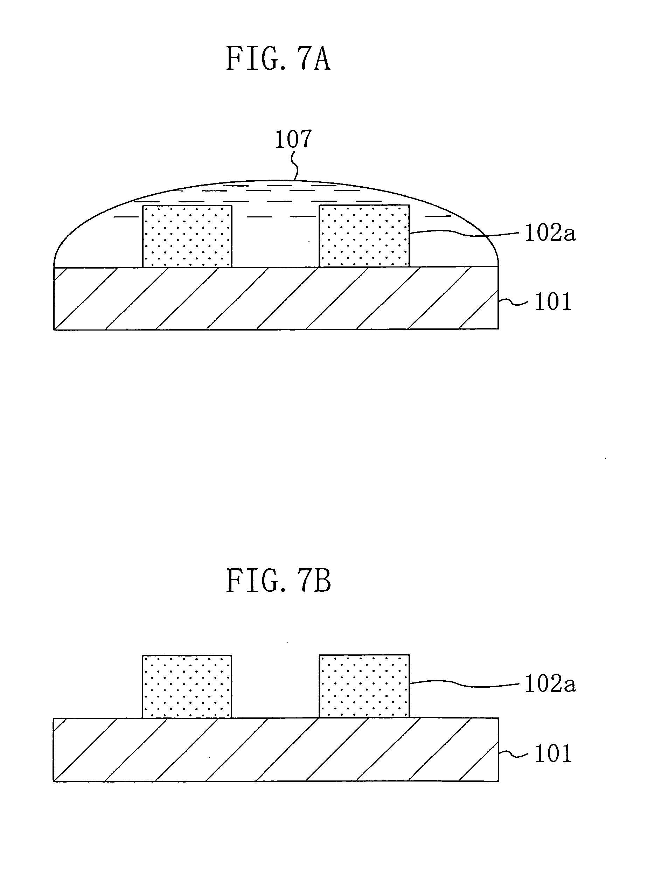

A pattern formation method according to Embodiment 3 of the invention will now be described with reference to FIGS. **6A** through **6D, 7A** and **7B**.

First, a positive chemically amplified resist material having the following composition is prepared:

> Base polymer: poly((norbornene-5-methylene-t-butylcarboxylate) (50 mol%) - (maleic anhydride) (50 mol%))          2 g
> Acid generator: triphenylsulfonium inflate          0.06 g
> Surface active agent: cetylmethylammonium chloride          0.0003 g
> Solvent: propylene glycol monomethyl ether acetate          20 g

Next, as shown in FIG. **6A,** the aforementioned chemically amplified resist material is applied on a substrate **101** so as to form a resist film **102** with a thickness of 0.5 μm.

Then, as shown in FIG. **6B,** pattern exposure is carried out by irradiating the resist film **102** with exposing light **103** of ArF excimer laser with NA of 0.68 through a mask **104**.

After the pattern exposure, as shown in FIG. **6C**, the resist film **102** is baked with a hot plate at a temperature of 110°C for 60 seconds (post exposure bake).

Then, as shown in FIG. **6D**, the resultant resist film **102** is developed with a 2.38 wt% tetramethylammonium hydroxide developing solution **105**.

Next, as shown in FIG. **7A,** the developed resist pattern **102a** is rinsed with a rinsing solution **107** of water including a surface active agent of 0.02 wt% nonylphenol ethoxylate. In this manner, a resist pattern **102a** made of an unexposed portion of the resist film **102** and having a line width of 0.09 μm is formed as shown in FIG. **7B**.

In this manner, according to the pattern formation method of Embodiment 3, not only the surface active agent of nonylphenol ethoxylate is included in the rinsing solution **107** used after the development but also the resist film **102** includes the surface active agent of cetylmethylammonium chloride. Therefore, the surface tension against the resist pattern **102a** caused when the rinsing solution **107** dries is definitely reduced. Accordingly, the resist pattern **102a** can be formed in a good shape without causing pattern collapse.

Although a cationic surface active agent of cetylmethylammonium chloride is included in the resist film **102** and a nonionic surface active agent of nonylphenol ethoxylate is included in the rinsing solution **107**, at least one of the cationic surface active agents and nonionic surface active agents mentioned in Embodiment 2 may be arbitrarily used.

EMBODIMENT 4

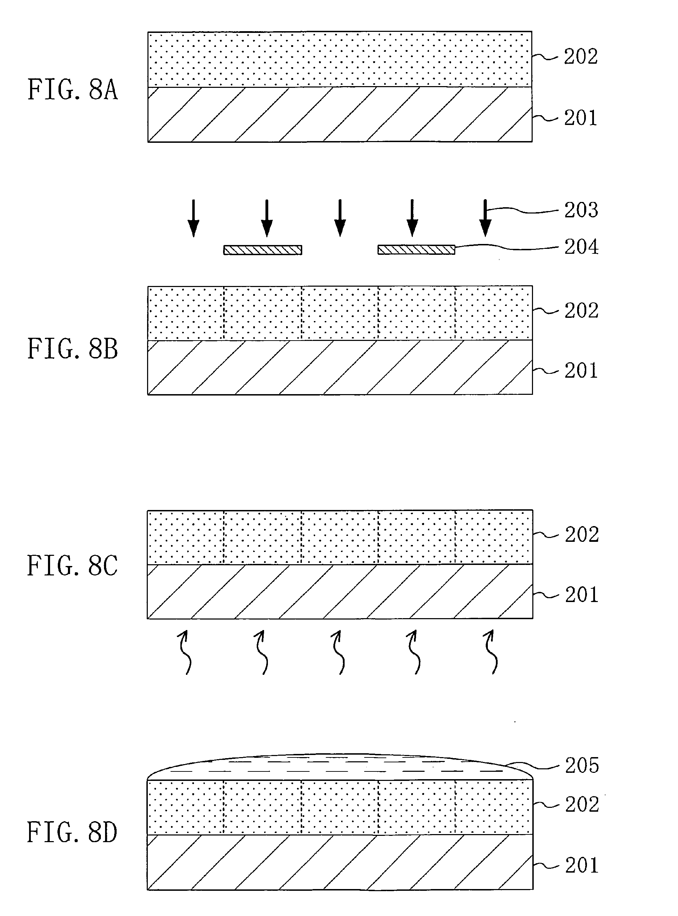

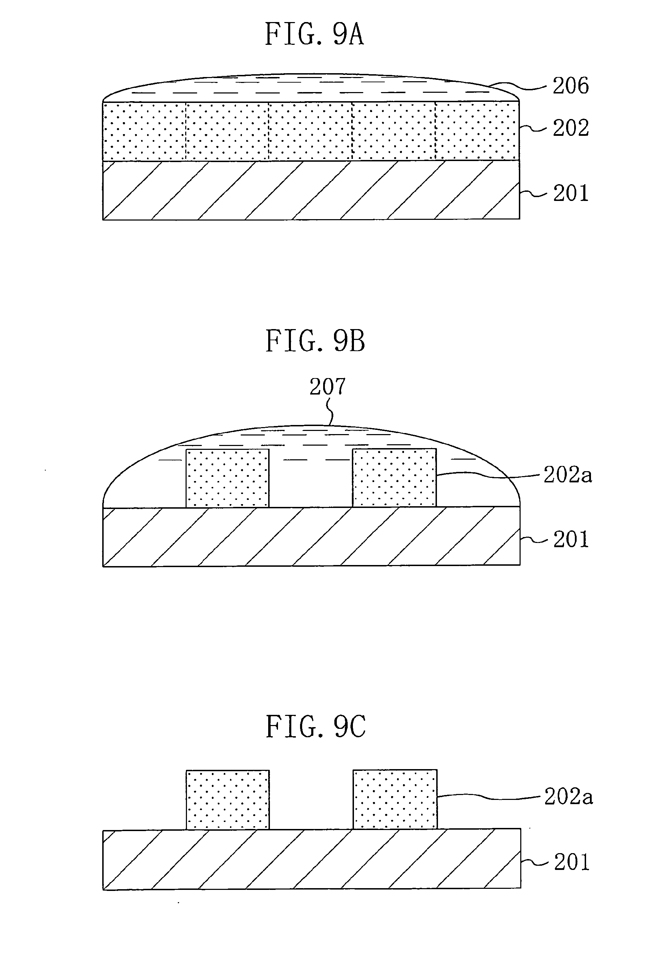

A pattern formation method according to Embodiment 4 of the invention will now be described with reference to FIGS. **8A** through **8D** and **9A** through **9C**.

First, a positive chemically amplified resist material having the following composition is prepared:

>     Base polymer: poly((norbornene-5-methylene-t-butylcarboxylate) (50 mol%) - (maleic anhydride) (50 mol%))     2 g
>     Acid generator: triphenylsulfonium triflate     0.06 g
>     Surface active agent: octylphenyl polyoxyethylene ether     0.0007 g
>     Solvent: propylene glycol monomethyl ether acetate     20 g

Next, as shown in FIG. **8A**, the aforementioned chemically amplified resist material is applied on a substrate **201** so as to form a resist film **202** with a thickness of 0.5 μm.

Then, as shown in FIG. **8B**, pattern exposure is carried out by irradiating the resist film **202** with exposing light **203** of ArF excimer laser with NA of 0.68 through a mask **204.**

After the pattern exposure, as shown in FIG. **8C,** the resist film **202** is baked with a hot plate at a temperature of 110°C for 60 seconds (post exposure bake).

Next, as shown in FIG. **8D**, the resultant resist film **202** is developed with a 2.38 wt% tetramethylammonium hydroxide developing solution **205**.

Then, as shown in FIG. **9A**, the developed resist film **202** is rinsed with water **206**.

Thereafter, as shown in FIG. **9B**, a resist pattern **202a** resulting from the development and having been rinsed with the water **206** is rinsed with a rinsing solution **207** of water including a surface active agent of 0.004 wt% stearylmethylammonium chloride. In this manner, the resist pattern **202a** made of an unexposed portion of the resist film **202** and having a line width of 0.09 μm is formed as shown in FIG. **9C**.

In this manner, according to the pattern formation method of Embodiment 4, not only the surface active agent of stearylmethylammonium chloride is included in the rinsing solution **207** used after the development but also the surface active agent of octylphenyl polyoxyethylene ether is included in the resist film **202**. Therefore, the surface tension against the resist pattern **202a** caused when the rinsing solution **207** dries is definitely reduced. Accordingly, the resist pattern **202a** can be formed in a good shape without causing pattern collapse.

In addition, in Embodiment 4, the resist film **202** is rinsed with the water **206** before rinsing it with the rinsing solution **207** after the development as shown in FIG. **9A**. Therefore, the activity of hydrophilic groups of the surface active agent included in the resist film **202** is improved, so that the surface tension caused when the rinsing solution **207** dries can be further reduced.

Although a nonionic surface active agent of octylphenyl polyoxyethylene ether is included in the resist film **202** and a cationic surface active agent of stearylmethylammonium chloride is included in the rinsing solution **207**, at least one of the cationic surface active agents and nonionic surface active agents mentioned in Embodiment 2 may be arbitrarily used.

EMBODIMENT 5

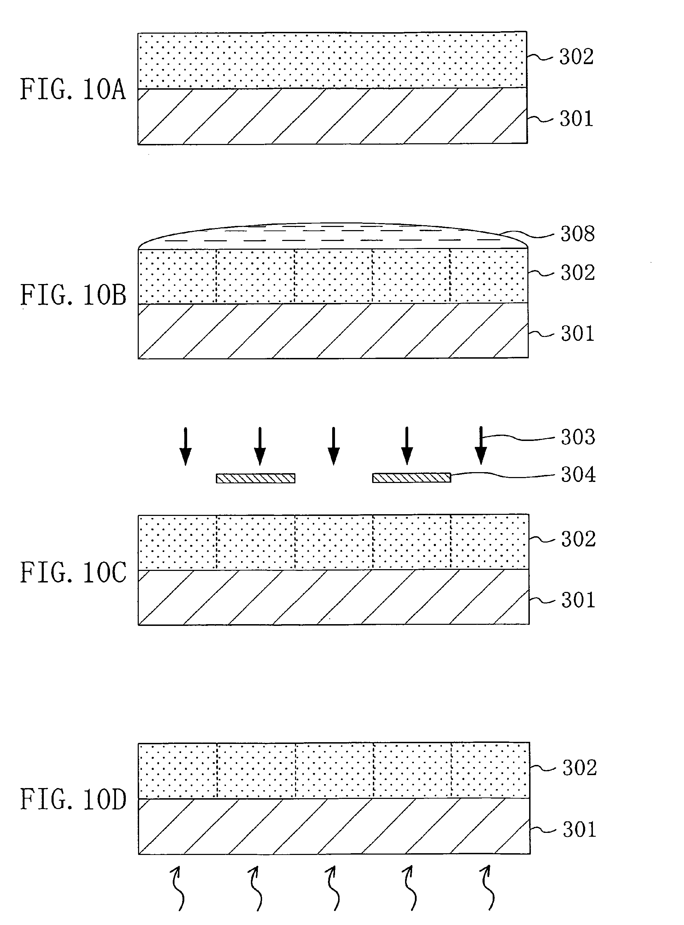

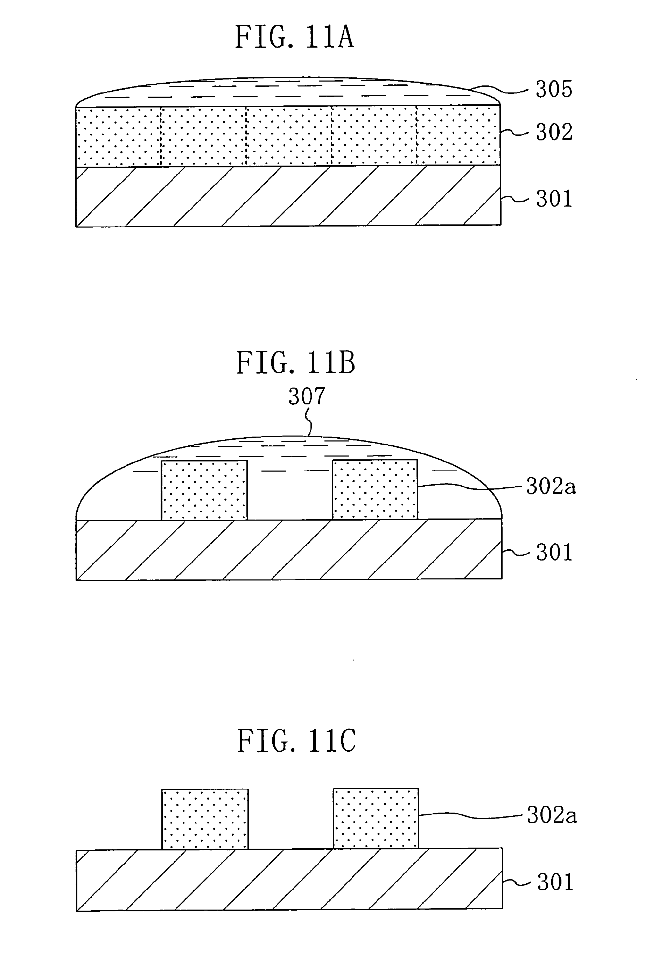

A pattern formation method according to Embodiment 5 of the invention will now be described with reference to FIGS. **10A** through **10D** and **11A** through **11C**.

First, a positive chemically amplified resist material having the following composition is prepared:

>     Base polymer: poly((norbornene-5-methylene-t-butylcarboxylate) (50 mol%) - (maleic anhydride) (50 mol%))     2 g
>     Acid generator: triphenylsulfonium triflate     0.06 g
>     Solvent: propylene glycol monomethyl ether acetate     20 g

Next, as shown in FIG. **10A,** the aforementioned chemically amplified resist material is applied on a substrate **301** so as to form a resist film **302** with a thickness of 0.5 μm.

Then, as shown in FIG. **10B**, the resist film **302** is exposed for 60 seconds to an aqueous solution **307** including a surface active agent of 0.02 wt% cetyltrimethylammonium chloride by, for example, a dip method.

Next, as shown in FIG. **10C,** pattern exposure is carried out by irradiating the resist film **302** with exposing light **303** of ArF excimer laser with NA of 0.68 through a mask **304**.

After the pattern exposure, as shown in FIG. **10D**, the resist film **302** is baked with a hot plate at a temperature of 110°C for 60 seconds (post exposure bake).

Next, as shown in FIG. **11A**, the resultant resist film **302** is developed with a 2.38 wt% tetramethylammonium hydroxide developing solution **305.**

Thereafter, a developed resist pattern **302a** is rinsed with a rinsing solution **307** of water including a surface active agent of 0.007 wt% lauryl polyoxyethylene ether. In this manner, the resist pattern **302a** made of an unexposed portion of the resist film **302** and having a line width of 0.09 μm is formed as shown in FIG. **11C**.

In this manner, according to the pattern formation method of Embodiment 5, not only the surface active agent of lauryl polyoxyethylene ether is included in the rinsing solution **307** used after the development but also the resist film **302** is exposed to the aqueous solution **308** including the surface active agent of cetyltrimethylammonium chloride. Therefore, the surface tension against the resist pattern **302a** caused when the rinsing solution **307** dries is definitely reduced. Accordingly, the resist pattern **302a** can be formed in a good shape without causing pattern collapse.

Although a cationic surface active agent of cetyltrimethylammonium chloride is included in the aqueous solution **308** used for exposing the resist film **302** and a nonionic surface active agent of lauryl polyoxyethylene ether is included in the rinsing solution **307**, at least one of the cationic surface active agents and nonionic surface active agents mentioned in Embodiment 2 may be arbitrarily used.

EMBODIMENT 6

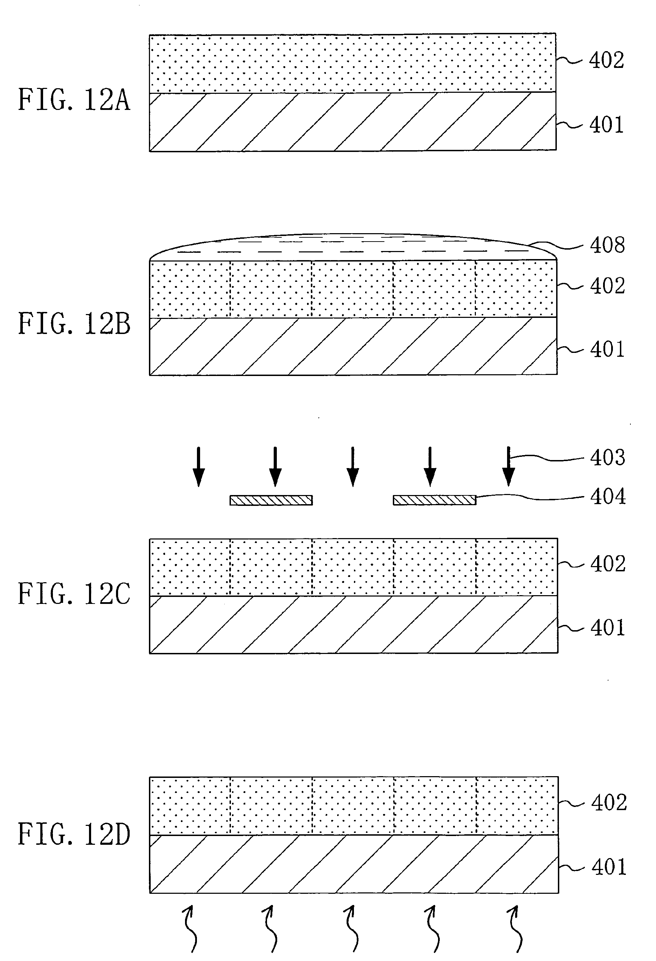

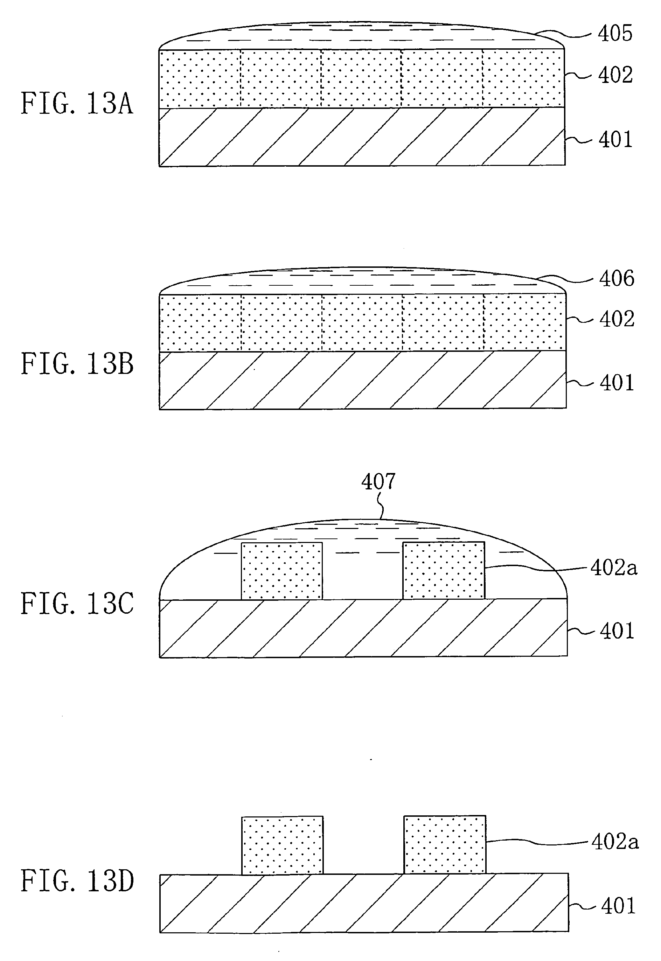

A pattern formation method according to Embodiment 6 of the invention will now be described with reference to FIGS. **12A** through **12D** and **13A** through **13D**.

First, a positive chemically amplified resist material having the following composition is prepared:

> Base polymer: poly((norbornene-5-methylene-t-butylcarboxylate) (50 mol%) - (maleic anhydride) (50 mol%)) 2 g
> Acid generator: triphenylsulfonium triflate 0.06 g
> Solvent: propylene glycol monomethyl ether acetate 20 g

Next, as shown in FIG. **12A**, the aforementioned chemically amplified resist material is applied on a substrate **401** so as to form a resist film **402** with a thickness of 0.5 μm.

Then, as shown in FIG. **12B,** the resist film **402** is exposed for 90 seconds to an aqueous solution **408** including a surface active agent of 0.002 wt% cetyl polyoxyethylene ether by, for example, the dip method.

Next, as shown in FIG. **12C,** pattern exposure is carried out by irradiating the resist film **402** with exposing light **403** of ArF excimer laser with NA of 0.68 through a mask **404.**

After the pattern exposure, as shown in FIG **12D**, the resist film **402** is baked with a hot plate at a temperature of 110°C for 60 seconds (post exposure bake).

Then, as shown in FIG. **13A**, the resultant resist film **402** is developed with a 2.38 wt% tetramethylammonium hydroxide developing solution **405.**

Next, as shown in FIG **13B**, the developed resist film **402** is rinsed with water **406**.

Thereafter, as shown in FIG. **13C,** a resist pattern **402a** resulting from the development and having been rinsed with the water **406** is rinsed with a rinsing solution **407** of water including a surface active agent of 0.0002 wt% stearyltrimethylammonium chloride. In this manner, the resist pattern **402a** made of an unexposed portion of the resist film **402** and having a line width of 0.09 μm is formed as shown in FIG. **13D**.

In this manner, according to the pattern formation method of Embodiment 6, not only the surface active agent of stearyltrimethylammonium chloride is included in the rinsing solution **407** used after the development but also the resist film **402** is exposed to the aqueous solution **408** including the surface active agent of cetyl polyoxyethylene ether. Therefore, the surface tension against the resist pattern **402a** caused when the rinsing solution **407** dries is definitely reduced. Accordingly, the resist pattern **402a** can be formed in a good shape without causing pattern collapse.

In addition, in Embodiment 6, the resist film **402** is rinsed with the water **406** before rinsing it with the rinsing solution **407** after the development as shown in FIG. **13B**. Therefore, the activity of hydrophilic groups of the surface active agent included in the resist film **402** is improved, so that the surface tension caused when the rinsing solution **407** dries can be further reduced.

Although a nonionic surface active agent of cetyl polyoxyethylene ether is included in the aqueous solution **408** used for exposing the resist film **402** and a cationic surface active agent of stearyltrimethylammonium chloride is included in the rinsing solution **407**, at least one of the cationic surface active agents and nonionic surface active agents mentioned in Embodiment 2 may be arbitrarily used.

Although the exposing light is the ArF excimer laser in each of Embodiments 1 through 6, the exposing light is not limited to the ArF excimer laser but may be KrF excimer laser, $F_2$ laser, ArKr laser, $Ar_2$ laser, extreme UV of a wavelength band not shorter than 1 nm and not longer than 30 nm, or electron beams.

A chemically amplified resist is used as the resist material in each embodiment, which does not limit invention. Also, the resist material is not limited to a positive resist but may be a negative resist.

## Claims

1. A pattern formation method comprising the steps of:

   forming a resist film on a substrate;
   performing pattern exposure by selectively irradiating said resist film with exposing light;
   developing said resist film after the pattern exposure; and
   forming a resist pattern by rinsing said resist film with an aqueous solution including cyclodextrin after the developing.

2. The pattern formation method of Claim 1, wherein said cyclodextrin is α-cyclodextrin, β-cyclodextrin, γ-cyclodextrin or δ-cyclodextrin.

3. A pattern formation method comprising the steps of:

   forming a resist film on a substrate;
   performing pattern exposure by selectively irradiating said resist film with exposing light;
   developing said resist film with a solution including cyclodextrin after the pattern exposure; and
   forming a resist pattern by rinsing said resist film with an aqueous solution after the developing.

4. The pattern formation method of Claim 3, wherein said aqueous solution includes cyclodextrin or a surface active agent.

5. The pattern formation method of Claim 3, wherein said cyclodextrin is α-cyclodextrin, β-cyclodextrin, γ-cyclodextrin or δ-cyclodextrin.

6. The pattern formation method of Claim 3, wherein said solution further includes a surface active agent.

7. A pattern formation method comprising the steps of:

   forming a resist film including a surface active agent on a substrate;
   performing pattern exposure by selectively irradiating said resist film with exposing light;
   developing said resist film after the pattern exposure; and
   forming a resist pattern by rinsing said resist film with an aqueous solution including a surface active agent after the developing.

8. The pattern formation method of Claim 7, further comprising a step of rinsing said resist film with water after the developing and before rinsing said resist film with said aqueous solution.

9. A pattern formation method comprising the steps of:

   forming a resist film on a substrate;
   exposing said resist film to a first aqueous solution including a surface active agent;
   performing pattern exposure by selectively irradiating said resist film with exposing light after exposing said resist film to said first aqueous solution;
   developing said resist film after the pattern exposure; and
   forming a resist pattern by rinsing said resist film with a second aqueous solution including a surface active agent after the developing.

10. The pattern formation method of Claim 9, further comprising a step of rinsing said resist film with water after the development and before rinsing said resist film with said second aqueous solution.

11. The pattern formation method of Claim 4, wherein said surface active agent is a cationic surface active agent or a nonionic surface active agent.

12. The pattern formation method of Claim 11, wherein said cationic surface active agent is cetylmethylammonium chloride, stearylmethylammonium chloride, cetyltrimethylammonium chloride, stearyltrimethylammonium chloride, distearyldimethylammonium chloride, stearyldimethylbenzylammonium chloride, dodecylmethylammonium chloride, dodecyltrimethylammonium chloride, benzylmethylammonium chloride, benzyltrimethylammonium chloride, benzalkonium chloride, 1,1-di(perfluoromethyl)-2-perfluoroethylethenyloxybenzyltrimethylammonium or 1,1-di(perfluoroisopropyl)-2-perfluoromethylethenyloxybenzyltrimethylammonium, and

   said nonionic surface active agent is nonyl phenol ethoxylate, octylphenyl polyoxyethylene ether, lauryl polyoxyethylene ether, cetyl polyoxyethylene ether, sucrose fatty ester, polyoxyethylene lanolin fatty ester, polyoxyethylene sorbitan fatty ester, polyoxyethylene glycol mono fatty ester, fatty monoethanolamide, fatty dietanolamide, fatty triethanolamide, 1,1-di(perfluoromethyl)-2-perfluoroethylethenyl polyoxyethylene ether or 1,1-di(perfluoroisopropyl)-2-perfluoromethylethenyl polyoxyethylene ether.

13. The pattern formation method of Claim 1, wherein said exposing light is KrF excimer laser, ArF excimer laser, $F_2$ laser, ArKr laser, $Ar_2$ laser,

extreme UV of a wavelength band not shorter than 1 nm and not longer than 30 nm, or electron beams.

14. The pattern formation method of Claim 3, wherein said exposing light is KrF excimer laser, ArF excimer laser, $F_2$ laser, ArKr laser, $Ar_2$ laser, extreme UV of a wavelength band not shorter than 1 nm and not longer than 30 nm, or electron beams.

15. The pattern formation method of Claim 7, wherein said surface active agent is a cationic surface active agent or a nonionic surface active agent.

16. The pattern formation method of Claim 15, wherein said cationic surface active agent is cetylmethylammonium chloride, stearylmethylammonium chloride, cetyltrimethylammonium chloride, stearyltrimethylammonium chloride, distearyldimethylammonium chloride, stearyldimethylbenzylammonium chloride, dodecylmethylammonium chloride, dodecyltrimethylammonium chloride, benzylmethylammonium chloride, benzyltrimethylammonium chloride, benzalkonium chloride, 1,1-di(perfluoromethyl)-2-perfluoroethylethenyloxybenzyltrimethylammonium or 1,1-di(perfluoroisopropyl)-2-perfluoromethylethenyloxybenzyltrimethylammonium, and
said nonionic surface active agent is nonyl phenol ethoxylate, octylphenyl polyoxyethylene ether, lauryl polyoxyethylene ether, cetyl polyoxyethylene ether, sucrose fatty ester, polyoxyethylene lanolin fatty ester, polyoxyethylene sorbitan fatty ester, polyoxyethylene glycol mono fatty ester, fatty monoethanolamide, fatty dietanolamide, fatty triethanolamide, 1,1-di(perfluoromethyl)-2-perfluoroethylethenyl polyoxyethylene ether or 1,1-di(perfluoroisopropyl)-2-perfluoromethylethenyl polyoxyethylene ether.

17. The pattern formation method of Claim 7, wherein said exposing light is KrF excimer laser, ArF excimer laser, $F_2$ laser, ArKr laser, $Ar_2$ laser, extreme UV of a wavelength band not shorter than 1 nm and not longer than 30 nm, or electron beams.

18. The pattern formation method of Claim 9, wherein said surface active agent is a cationic surface active agent or a nonionic surface active agent.

19. The pattern formation method of Claim 18, wherein said cationic surface active agent is cetylmethylammonium chloride, stearylmethylammonium chloride, cetyltrimethylammonium chloride, stearyltrimethylammonium chloride, distearyldimethylammonium chloride, stearyldimethylbenzylammonium chloride, dodecylmethylammonium chloride, dodecyltrimethylammonium chloride, benzylmethylammonium chloride, benzyltrimethylammonium chloride, benzalkonium chloride, 1,1-di(perfluoromethyl)-2-perfluoroethylethenyloxybenzyltrimethylammonium or 1,1-di(perfluoroisopropyl)-2-perfluoromethylethenyloxybenzyltrimethylammonium, and
said nonionic surface active agent is nonyl phenol ethoxylate, octylphenyl polyoxyethylene ether, lauryl polyoxyethylene ether, cetyl polyoxyethylene ether, sucrose fatty ester, polyoxyethylene lanolin fatty ester, polyoxyethylene sorbitan fatty ester, polyoxyethylene glycol mono fatty ester, fatty monoethanolamide, fatty dietanolamide, fatty triethanolamide, 1,1-di(perfluoromethyl)-2-perfluoroethylethenyl polyoxyethylene ether or 1,1-di(perfluoroisopropyl)-2-perfluoromethylethenyl polyoxyethylene ether.

20. The pattern formation method of Claim 9, wherein said exposing light is KrF excimer laser, ArF excimer laser, $F_2$ laser, ArKr laser, $Ar_2$ laser, extreme UV of a wavelength band not shorter than 1 nm and not longer than 30 nm, or electron beams.

# FIG. 1

74

72a

73

72a

71

FIG. 2A

82

81

83

84

FIG. 2B

82

81

FIG. 2C

82

81

FIG. 2D

85

82

81

FIG. 3A

86

82

81

FIG. 3B

82a

81

FIG. 4A

— 92
— 91

— 93
— 94

FIG. 4B

— 92
— 91

FIG. 4C

— 92
— 91

FIG. 4D

— 95
— 92
— 91

## FIG. 5A

96
92
91

## FIG. 5B

92a
91

FIG. 6A

~ 102

~ 101

~ 103

~ 104

FIG. 6B

~ 102

~ 101

FIG. 6C

~ 102

~ 101

FIG. 6D

~ 105

~ 102

~ 101

# FIG. 7A

107

102a

101

# FIG. 7B

102a

101

FIG. 8A

202

201

FIG. 8B

203

204

202

201

FIG. 8C

202

201

FIG. 8D

205

202

201

## FIG. 9A

206
202
201

## FIG. 9B

207
202a
201

## FIG. 9C

202a
201

FIG. 10A

302
301

FIG. 10B

308
302
301

303
304

FIG. 10C

302
301

FIG. 10D

302
301

## FIG. 11A

305
302
301

## FIG. 11B

307
302a
301

## FIG. 11C

302a
301

FIG. 12A

402

401

FIG. 12B

408

402

401

403

404

FIG. 12C

402

401

FIG. 12D

402

401

FIG. 13A

— 405
— 402
— 401

FIG. 13B

— 406
— 402
— 401

407

FIG. 13C

— 402a
— 401

FIG. 13D

— 402a
— 401

FIG. 14A
PRIOR ART

FIG. 14B
PRIOR ART

FIG. 14C
PRIOR ART

FIG. 14D
PRIOR ART

# FIG. 15A

PRIOR ART

6

2

1

# FIG. 15B

PRIOR ART

2a

1

EP 1 553 454 A2

FIG. 16
PRIOR ART

26